# EUROPEAN PATENT APPLICATION

(11) **EP 4 583 665 A1**
(43) Date of publication of application: **09.07.2025**
(21) Application number: 24202565.8
(22) Date of filing: 25.09.2024
(51) Int. Cl.: H10D 62/10, H10D 30/00, H10D 30/67, H10D 64/01, H10D 30/01

(54) **SEMICONDUCTOR DEVICE INCLUDING INNER SPACERS HAVING DIFFERENT DIMENSIONS**

(30) Priority: 08.01.2024 KR 20240002727; 21.02.2024 KR 20240025046
(71) Applicant: Samsung Electronics Co., Ltd., Suwon-si, Gyeonggi-do 16677 (KR)
(72) Inventor: YU, Hyunkwan, 16677 Suwon-si, Gyeonggi-do (KR); SHIN, Dongsuk, 16677 Suwon-si, Gyeonggi-do (KR)
(74) Representative: Kuhnen & Wacker Patent- und Rechtsanwaltsbüro PartG mbB

(57) **Abstract**

A semiconductor device includes: a gate structure (160) having a side in a first direction (X) and extending in a second direction (Y) intersecting the first direction (X); a source/drain (130) region on the side of the gate structure (160); a plurality of channel layers (141, 142, 143) spaced apart from each other in a third direction (Z) intersecting the first direction (X) and the second direction (Y) and surrounded by the gate structure (160); and a plurality of inner spacers between the gate structure (160) and the source/drain region (130), wherein the plurality of inner spacers have respective heights in the third direction (Z) increasing in the third direction (Z) toward bottom, and have respective thicknesses in the first direction (X) decreasing in the third direction (Z) toward bottom.

## Description

### BACKGROUND

The present disclosure relates to a semiconductor device.

As demands for high performance, speed, and/or multifunctionality for semiconductor devices increase, the degree of integration of semiconductor devices is increasing. In manufacturing fine-patterned semiconductor devices in response to the trend for high integration of semiconductor devices, implementing patterns having a fine width or a fine spacing distance may be required. Additionally, to reduce limitations in operating characteristics due to a size reduction of a planar metal oxide semiconductor field-effect transistor (MOSFET), efforts are underway to develop semiconductor devices including fin field-effect transistors (FinFETs) and nanosheet transistors having channels in a three-dimensional structure.

### SUMMARY

Example embodiments provide a semiconductor device having improved degrees of integration and reliability.

According to example embodiments, a semiconductor device includes: a gate structure having a side in a first direction and extending in a second direction intersecting the first direction; a source/drain region on the side of the gate structure; a plurality of channel layers spaced apart from each other in a third direction intersecting the first direction and the second direction and surrounded by the gate structure; ; and a plurality of inner spacers between the gate structure and the source/drain region, wherein the plurality of inner spacers have respective heights in the third direction increasing in the third direction toward bottom, and have respective thicknesses in the first direction decreasing in the third direction toward bottom.

According to example embodiments, a semiconductor device includes: a plurality of channel layers extended in a first direction, and spaced apart from each other in a third direction intersecting the first and second directions; a gate structure on the plurality of channel layers, the gate structure being extended in a 2^{nd} direction intersecting the 1^{st} direction and the 3^{rd} direction; a source/drain region on a side of the gate structure in the first direction; and a plurality of inner spacers between the gate structure and the source/drain region, wherein a first inner spacer disposed on a highest level among the plurality of inner spacers has a smaller height in the third direction and a greater thickness in the first direction than a second inner spacer at a lower level.

According to example embodiments, a semiconductor device includes: a plurality of channel layers extended in a first direction, including a first channel layer, a second channel layer and a third channel layer disposed sequentially from top and spaced apart from each other in a third direction, intersecting the first direction; a gate structure on the plurality of channel layers, the gate structure being extended in a 2^{nd} direction intersecting the 1^{st} direction and the 3^{rd} direction; a source/drain region on a side of the gate structure in the first direction; and a plurality of inner spacers separating the gate structure from the source/drain region, and including a first inner spacer, a second inner spacer, and a third inner spacer sequentially disposed from top, wherein the gate structure includes a first gate portion on the first inner spacer, a second gate portion on the second inner spacer, and a third gate portion on the third inner spacer, and wherein one of the first to third gate portions has a height in the third direction and a width in the first direction different from a height and a width of each of the other gate portions.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a schematic top view illustrating a semiconductor device according to example embodiments;
FIG. 2 is a schematic cross-sectional view illustrating a semiconductor device according to example embodiments;
FIGS. 3A to 3E are partially enlarged views illustrating semiconductor devices according to example embodiments;
FIG. 4 is a schematic cross-sectional view illustrating a semiconductor device according to example embodiments;
FIGS. 5A to 5D are partially enlarged views illustrating semiconductor devices according to example embodiments;
FIGS. 6A to 6F and FIGS. 8A to 8B are cross-sectional views illustrated according to a process sequence to describe a method of manufacturing a semiconductor device according to example embodiments;
FIGS. 7A and 7B are partially enlarged views illustrating a process sequence to describe a method of manufacturing a semiconductor device according to example embodiments;
FIG. 9 is a cross-sectional view illustrating a process sequence to describe a method of manufacturing a semiconductor device according to example embodiments; and
FIGS. 10A and 10B are partially enlarged views illustrating a process sequence to describe a method of manufacturing a semiconductor device according to example embodiments.

### DETAILED DESCRIPTION

The example embodiments described herein are non-limiting example embodiments, and thus, the disclosure is not limited thereto and may be realized in various other forms. Each of the example embodiments provided herein is not excluded from being associated with one or more features of another example or another example embodiment also provided herein or not provided herein but consistent with the disclosure. For example, even if matters described in a specific example or embodiment are not described in a different example or embodiment, the matters may be understood as being related to or combinable with the different example or embodiment, unless otherwise mentioned in descriptions thereof.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c. Herein, when a term "same" or "equal" is used to compare a dimension of two or more elements, the term may cover a "substantially same" or "substantially equal" dimension.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

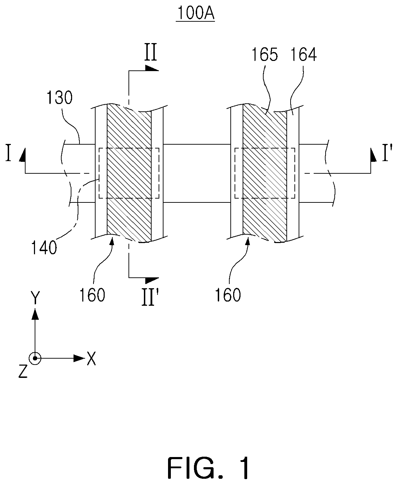

FIG. 1 is a top view illustrating a semiconductor device according to example embodiments. For convenience of descriptions, only some components of the semiconductor device are illustrated in FIG. 1.

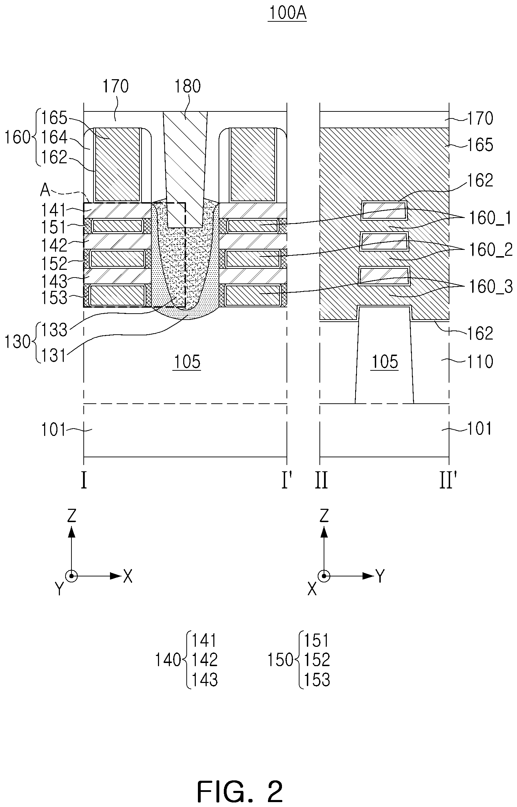

FIG. 2 is a schematic cross-sectional view illustrating a semiconductor device according to example embodiments. FIG. 2 schematically illustrates cross sections of the semiconductor device of FIG. 1 along cutting lines I-I' and II-II'.

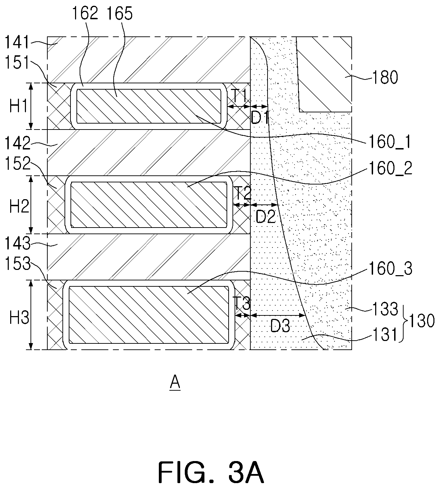

FIG. 3A is a partially enlarged view illustrating a semiconductor device according to example embodiments. FIG. 3A illustrates an enlarged view of the area 'A' of the semiconductor device of FIG. 2.

Referring to FIGS. 1 to 3A, a semiconductor device 100A may include a substrate 101 including an active region 105, channel structures 140 including first to third channel layers 141, 142, and 143 disposed to be vertically spaced from each other on the active region 105, gate structures 160 extending across the active region 105 and each including a gate electrode 165, a source/drain region 130 that contacts the channel structures 140 and includes a first epitaxial layer 131 and a second epitaxial layer 133, a plurality of inner spacers 150 disposed between the gate structure 160 and the source/drain region 130 below the respective channel layers 141, 142, and 143, and a contact structure 180 connected to the source/drain region 130. The semiconductor device 100A may further include a device isolation layer 110 and an interlayer insulating layer 170.

In the semiconductor device 100A, the active region 105 has a fin structure, and the gate electrode 165 may be disposed between the active region 105 and the channel structure 140, between first to third channel layers 141, 142, and 143 of the channel structure 140, and on the channel structure 140. Accordingly, the semiconductor device 100A may include transistors with a nanosheet transistor or a Multi Bridge Channel FET (MBCFET^{™}) structure, which is a gate-all-around type field effect transistor.

The substrate 101 may have an upper surface extending in the X and Y-directions. The substrate 101 may include a semiconductor material, such as a group IV semiconductor, a group III-V compound semiconductor, or a group II-VI compound semiconductor. For example, Group IV semiconductors may include silicon, germanium, or silicon-germanium. The substrate 101 may be provided as a bulk wafer, an epitaxial layer, a Silicon On Insulator (SOI) layer, a Semiconductor On Insulator (SeOI) layer, or the like.

The substrate 101 may include an active region 105 disposed in the upper portion. The active region 105 may be defined by the device isolation layer 110 within the substrate 101 and may be disposed to extend in a first direction, for example, the X-direction. However, depending on the explanation method, it may be possible to describe the active region 105 as a separate configuration from the substrate 101. The active region 105 partially protrudes upwardly of the device isolation layer 110, so that the upper surface of the active region 105 may be disposed on a higher level than the upper surface of the device isolation layer 110. The active region 105 may be formed as a portion of the substrate 101 or may include an epitaxial layer grown from the substrate 101. However, on both sides of the gate structure 160, the active region 105 is partially recessed to form a recess region, and the source/drain region 130 may be disposed in the recess region.

In example embodiments, the active region 105 may or may not include a well region containing impurities. For example, in the case of a p-type transistor (pFET), the well region may include n-type impurities such as phosphorus (P), arsenic (As), or antimony (Sb), and in the case of an n-type transistor (nFET), the well region may include p-type impurities such as boron (B), gallium (Ga), or indium (In). For example, the well region may be disposed to a predetermined depth from the upper surface of the active region 105.

The device isolation layer 110 may define the active region 105 within the substrate 101. For example, the device isolation layer 110 may be formed through a shallow trench isolation (STI) process. The device isolation layer 110 may expose the upper surface of the active region 105 and may partially expose the upper portion. In some embodiments, the device isolation layer 110 may have a curved upper surface to have a higher level as it is adjacent to the active region 105. The device isolation layer 110 may be formed of an insulating material. The device isolation layer 110 may be, for example, oxide, nitride, or a combination thereof (e.g., SiO₂).

The gate structures 160 may be disposed on the active region 105 and the channel structures 140 to intersect the active region 105 and the channel structures 140 and extend in a second direction, for example, the Y-direction. Functional channel regions of transistors may be formed in the active region 105 and/or the channel structures 140 that intersect the gate electrodes 165 of the gate structures 160. Each of the gate structures 160 may include a gate electrode 165, gate dielectric layers 162 between the gate electrode 165 and the first to third channel layers 141, 142, and 143, and gate spacer layers 164 on sides of the gate electrode 165. The gate structure 160 may include a first gate portion 160_1 disposed at the same level as the first inner spacer 151 below the first channel layer 141, a second gate portion 160_2 disposed at the same level as the second inner spacer 152 below the second channel layer 142, and a third gate portion 160_3 disposed at the same level as the third inner spacer 153 below the third channel layer 143. Surfaces of the first gate portion 160_1 in the third direction (for example, Z-direction) may contact the first channel layer 141 and the second channel layer 142, and the side surfaces thereof in the first direction (for example, X-direction) may contact the first inner spacer 151. Surfaces of the second gate portion 160_2 in the third direction (for example, Z-direction) may contact the second channel layer 142 and the third channel layer 143, and the sides thereof in the first direction (for example, X-direction) may contact the second inner spacer 152. Surfaces of the third gate portion 160_3 in the third direction (for example, Z-direction) may contact the third channel layer 143 and the active region 105, and the sides thereof in the first direction (for example, X-direction) may be in contact with the third inner spacer 153. In a first direction (for example, X-direction), the distance between the second gate portion 160_2 and the source/drain region 130 may be greater than the distance between the first gate portion 160_1 and the source/drain region 130, and the distance between the third gate portion 160_3 and the source/drain region 130 may be greater than the distance between the second gate portion 160_2 and the source/drain region 130. The height H2 of the second gate portion 160_2 may be greater than the height H1 of the first gate portion 160_1, and the height H3 of the third gate portion 160_3 may be greater than the height H2 of the second gate portion 160_2. In example embodiments, the height H3 of the third gate portion 160_3 may be greater than the height of each of the plurality of channel layers 141, 142, and 143.

The gate dielectric layers 162 may be disposed between the active region 105 and the gate electrode 165 and between the channel structure 140 and the gate electrode 165, and may be disposed to cover at least some of the surfaces of the gate electrode 165. For example, the gate dielectric layers 162 may be disposed to surround all surfaces of the gate electrode 165 except the upper surface. The gate dielectric layers 162 may contact the plurality of inner spacers 150 below the plurality of channel layers 141, 142, and 143. The gate dielectric layers 162 may extend between the gate electrode 165 and the gate spacer layers 164, but are not limited thereto. The gate dielectric layers 162 may include oxide, nitride, or a high-k material. The high-k material may refer to a dielectric material having a higher dielectric constant than a silicon oxide film (SiO₂). The high-k material may be any one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). Depending on example embodiments, the gate dielectric layer 162 may be formed of a multilayer film.

The gate electrode 165 may be disposed to fill the space between the first to third channel layers 141, 142, and 143 on the active region 105 and extend onto the channel structure 140. The gate electrode 165 may be spaced apart from the first to third channel layers 141, 142, and 143 by gate dielectric layers 162. The gate electrode 165 may include a conductive material, for example, a metal nitride such as titanium nitride (TiN), tantalum nitride (TaN), or tungsten nitride (WN), and/or a metallic material such as aluminum (Al), tungsten (W), or molybdenum (Mo), or a semiconductor material such as doped polysilicon. Depending on example embodiments, the gate electrode 165 may be composed of two or more multiple layers including a work-function metal layer.

The gate spacer layers 164 may be disposed on both sides of the gate electrode 165 on the channel structure 140. The gate spacer layers 164 may insulate the source/drain region 130 from the gate electrode 165. The gate spacer layers 164 may have a multilayer structure, depending on example embodiments. The gate spacer layers 164 may be formed of at least one of oxide, nitride, and oxynitride, and may be formed of, for example, a low dielectric constant film.

The channel structures 140 may be disposed on the active region 105 in regions in which the active region 105 intersects the gate structures 160. Each of the channel structures 140 may include first to third channel layers 141, 142, and 143, which are a plurality of channel layers disposed to be spaced apart from each other in the Z-direction. The first to third channel layers 141, 142, and 143 may be sequentially disposed from the top, and the first channel layer 141 may be the uppermost channel layer. The channel structures 140 may be connected to the source/drain region 130. The channel structures 140 may have a width equal to or similar to the width of the gate structures 160 in the X-direction, and may have a width equal to or smaller than the width of the active region 105 in the Y-direction. In a cross section in the Y-direction, a channel layer disposed at the lower portion from among the first to third channel layers 141, 142, and 143 may have a width equal to or greater than the width of the channel layer disposed at the upper portion. The number and shape of channel layers forming one channel structure 140 may vary in various embodiments. For example, one channel structure 140 may include four channel layers, two channel layers, or five or more channel layers.

The channel structures 140 may be formed of a semiconductor material, and may include at least one of, for example, silicon (Si), silicon germanium (SiGe), and germanium (Ge). For example, the channel structures 140 may be formed of the same material as the active region 105. In some embodiments, the channel structures 140 may include an impurity region in an area adjacent to the source/drain region 130.

The source/drain regions 130 may be disposed to contact the channel structures 140 on both sides or one side of the gate structure 160. The source/drain region 130 may be disposed on the side surfaces of the respective first to third channel layers 141, 142, and 143 of the channel structure 140 in the X-direction. The source/drain region 130 may be connected to the contact structure 180 through an upper surface or an upper end thereof. The upper region of the source/drain region 130 may have a recessed shape by the contact structure 180. The source/drain region 130 may be electrically connected to the contact structure 180. The upper surfaces of the source/drain regions 130 may be disposed at the same level or higher than the lower surfaces of the gate electrodes 165 on the channel structures 140, and the levels may vary in various embodiments.

The source/drain region 130 may be an epitaxially grown region and may include a plurality of epitaxial layers. For example, the source/drain region 130 may include first and second epitaxial layers 131 and 133 sequentially disposed from the bottom. The first epitaxial layer 131 may be formed on the side surfaces of the respective first to third channel layers 141, 142, and 143 in the X-direction, and side surfaces of the plurality of respective inner spacers 151, 152, and 153 in the X-direction below the channel structure 140. The first epitaxial layer 131 may be formed on the inner side surface of the recess region of the active region 105 in which the source/drain region 130 is disposed.

The second epitaxial layer 133 may be formed on the first epitaxial layer 131 and fill a recess region between the channel structures 140 in the X-direction, on the first epitaxial layer 131. The width of the second epitaxial layer 133 may decrease as the level decreases, and the distance between the second epitaxial layer 133 and the gate structure 160 in the first direction (for example, X-direction) may increase as the level decreases. For example, the distance between the second epitaxial layer 133 and the third gate portion 160_3 in the first direction (for example, X-direction) may be greater than the distances between the second epitaxial layer 133 and the first and second gate portions 160_1 and 160_2 in the first direction. The distance between the second epitaxial layer 133 and the plurality of inner spacers 151, 152, and 153 in the first direction (for example, X-direction) may increase as the level decreases. For example, the distance D3 between the third inner spacer 153 and the second epitaxial layer 133 in the first direction (for example, X-direction) may be greater than distances D1 and D2 at which the first and second inner spacers 151 and 152 are spaced apart from the second epitaxial layer 133 in the first direction (for example, X-direction). Some of the surfaces in the upper region of the second epitaxial layer 133 may be in contact with the contact structure 180 and may have a curved or angled shape following the shape of the contact structure 180.

The source/drain region 130 may include a semiconductor material, for example, at least one of silicon (Si) and germanium (Ge), and may further include impurities. The first to second epitaxial layers 131 and 133 may have different compositions. For example, the first epitaxial layer 131 may include a first concentration of a non-silicon element, and the second epitaxial layer 133 may have a second concentration of the non-silicon element, higher than the first concentration. The non-silicon element may be, for example, germanium (Ge) and/or a doping element.

The second epitaxial layer 133 may have a higher doping concentration of doping elements, for example, impurities, than that of the first epitaxial layer 131. Accordingly, the specific resistance of the second epitaxial layer 133 may be lower than the specific resistance of the first epitaxial layer 131. When the semiconductor device 100 is a pFET, the impurities may be at least one of boron (B), gallium (Ga), and indium (In), and in the case of nFET, the impurities may be at least one of phosphorus (P), arsenic (As), and antimony (Sb).

The interlayer insulating layer 170 may be disposed on the upper surface of the device isolation layer 110 and the source/drain region 130. The interlayer insulating layer 170 may include at least one of oxide, nitride, and oxynitride, and may include, for example, a low dielectric constant material. Depending on example embodiments, the interlayer insulating layer 170 may include a plurality of insulating layers.

A plurality of inner spacers 150 may be disposed between the gate structure 160 and the source/drain region 130, below the plurality of respective channel layers 141, 142, and 143 on the active region 105. The plurality of inner spacers 150 may be disposed in parallel with the gate electrode 165 below the respective first to third channel layers 141, 142, and 143. The plurality of inner spacers 150 may be formed on side surfaces of the gate structure 160 below the channel structure 140 in the X-direction. The side surfaces of the plurality of inner spacers 150 contacting the gate structure 160 may be concave toward the gate structure 160. The upper and lower ends of the sides of the plurality of inner spacers 150 facing the gate structure 160 may have a shape that protrudes toward the gate structure 160. For example, the first to third gate portions 160_1, 160_2, and 160_3 may respectively have a convex shape toward the first to third inner spacers 151, 152, and 153. The center thicknesses T1, T2, and T3 of the respective inner spacers 150 may be the minimum thicknesses, and respective top and bottom thicknesses thereof may be maximum thicknesses. In this case, the center thickness may be understood to refer to the thickness at the center in the third direction (for example, Z-direction). Depending on the shape of the source/drain region 130, the processing method and order of the inner spacers 150, or the like, the shape of the inner spacers 150 may be changed in various manners. The inner spacer 150 may include an insulating material and may include at least one of oxide, nitride, and oxynitride. For example, the inner spacer 150 may include at least one of silicon oxide (SiO), silicon nitride (SiN), and silicon oxynitride (SiON). The gate electrode 165 may be stably spaced apart and electrically separated from the source/drain region 130 by the plurality of inner spacers 150.

The first to third inner spacers 151, 152, and 153 may be sequentially disposed from the top, and the first inner spacer 151 may be the uppermost inner spacer. The first inner spacer 151 may be disposed below the first channel layer 141, the second inner spacer 152 may be disposed below the second channel layer 142, and the third inner spacer 153 may be disposed below the third channel layer 143. The height H2 of the second inner spacer 152 may be greater than the height H1 of the first inner spacer 151, and the height H3 of the third inner spacer 153 may be greater than the height H2 of the second inner spacer 152. Conversely, the central thickness T2 of the second inner spacer 152 may be smaller than the central thickness T1 of the first inner spacer 151, and the central thickness T3 of the third inner spacer 153 may be smaller than the central thickness T2 of the second inner spacer. For example, the first to third inner spacers 151, 152, and 153 sequentially from the top have a greater height in the third direction (for example, Z-direction) toward the bottom, and the central thickness thereof in the first direction may be smaller. The contact area of the first channel layer 141 and the first inner spacer 151 may be greater than the contact area of the second channel layer 142 and the second inner spacer 152, and the contact area of the second channel layer 142 and the second inner spacer 152 may be greater than the contact area of the third channel layer 143 and the third inner spacer 153.

By having a structure in which the thickness of the inner spacer 150 disposed at a relatively high level among the plurality of inner spacers 150 is greater than the thickness of the inner spacer 150 disposed at a low level, the second epitaxial layer 133, which has a high non-silicon concentration, and the gate structure 160 may be stably spaced apart. Accordingly, a semiconductor device having improved reliability may be provided.

The contact structure 180 may be disposed on source/drain region 130. The contact structure 180 is connected to the source/drain region 130 and may apply an electrical signal to the source/drain region 130. The contact structure 180 may recess the source/drain region 130 and extend into the source/drain region 130. The contact structure 180 may have an inclined side surface so that the width thereof decreases toward the source/drain region 130 due to the aspect ratio, but is not limited thereto. As in the present embodiment, the contact structure 180 may extend from a level of the upper portion of the channel structure 140 below a level of the lower surface of the first channel layer 141, which is the first channel layer, and depending on example embodiments, may extend below a level of the lower surface of the second channel layer 142 or the third channel layer 143. The contact structure 180 may include a metal material such as, for example, tungsten (W), cobalt (Co), molybdenum (Mo), copper (Cu), ruthenium (Ru), or aluminum (Al).

In the description of the following embodiments, descriptions that overlap with those described above with reference to FIGS. 1 to 3A will be omitted.

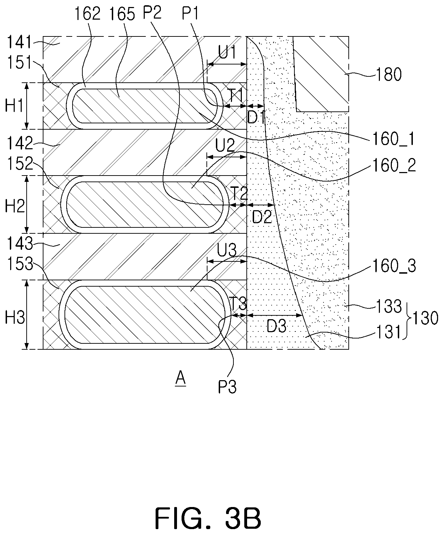

FIGS. 3B to 3E are partially enlarged views illustrating semiconductor devices according to example embodiments. FIGS. 3B to 3I illustrate enlarged areas corresponding to the enlarged area 'A' of the semiconductor device in FIG. 2, and illustrate modified examples of FIG. 3A. The detailed form of the plurality of inner spacers 150 is not limited to the example embodiments of FIGS. 3A to 3E.

Referring to FIG. 3B together with FIG. 2, the side of the inner spacer 150 facing the gate structure 160 may have a concave rounded shape toward the gate structure 160. Accordingly, the first to third gate portions 160_1, 160_2, and 160_3 may respectively have a convexly rounded shape toward the respective first to third inner spacers 151, 152, and 153. The first to third gate portions 160_1, 160_2, and 160_3 may have protruding ends P1, P2, and P3 that protrude most toward the source/drain region 130. The first protruding end P1 of the first gate portion 160_1 may contact a portion of the first inner spacer 151 having a minimum thickness T1, and the first protruding end P1 may be spaced apart from the first and second channel layers 141 and 142. The second protruding end P2 of the second gate portion 160_2 may contact a portion of the second inner spacer 152 having a minimum thickness T2, and the second protruding end P2 may be spaced apart from the second and third channel layers 142 and 143. The third protruding end P3 of the third gate portion 160_3 may contact a portion of the third inner spacer 153 having a minimum thickness T3, and the third protruding end P3 may be spaced apart from the third channel layer 143 and the active region 105. Similar to the example embodiment of FIG. 3A, the central thickness T2 of the second inner spacer 152 may be smaller than the central thickness T1 of the first inner spacer 151, and the central thickness T3 of the third inner spacer 153 may be smaller than the central thickness T2 of the second inner spacer 152.

However, unlike the example embodiment of FIG. 3A, the size relationship between the upper thicknesses U1, U2, and U3 of the respective first to third inner spacers 151, 152, and 153 may be different from size relationship of respective center thicknesses T1, T2 and T3. For example, the upper thicknesses U1, U2, and U3 of the first to third inner spacers 151, 152, and 153 may have substantially the same size. Alternatively, the upper thickness U1 of the first inner spacer 151 may be smaller than the top thickness U2 of the second inner spacer 152, or the top thickness U2 of the second inner spacer 152 may be smaller than the top thickness U3 of the third inner spacer 153, and like this, the size relationships thereof may be changed in various manners. The description regarding the upper thicknesses U1, U2, and U3 of the plurality of respective inner spacers 151, 152, and 153 may also be applied to the lower thicknesses of the plurality of respective inner spacers 151, 152, and 153.

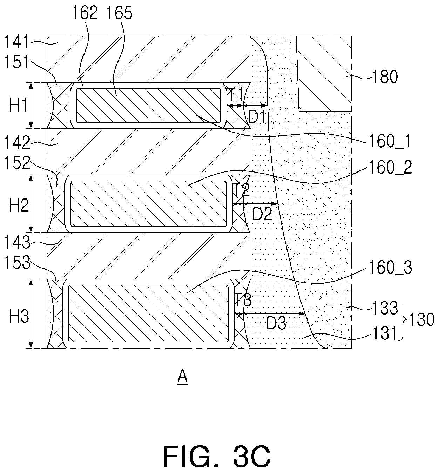

Referring to FIG. 3C together with FIG. 2, the first epitaxial layer 131 may have outer side surfaces that protrude convexly toward the gate structures 160, below the channel structures 140, and accordingly, the outer side surfaces may have curves. The side portions of the source/drain region 130 in contact with the plurality of inner spacers 151, 152, and 153 may protrude more toward the gate structure 160 than the side portions thereof in contact with the plurality of channel layers 141, 142, and 143. As the side of the source/drain region 130 has a shape that protrudes toward the gate electrode 165, between the plurality of channel layers 141, 142, and 143, side surfaces of the plurality of respective inner spacers 150 in contact with the source/drain region 130 may be concave toward the source/drain region 130. In this case, as in the example embodiment of FIG. 3A, the central thickness T2 of the second inner spacer 152 may be smaller than the central thickness T1 of the first inner spacer 151, and the central thickness T3 of the third inner spacer 153 may be smaller than the central thickness T2 of the second inner spacer.

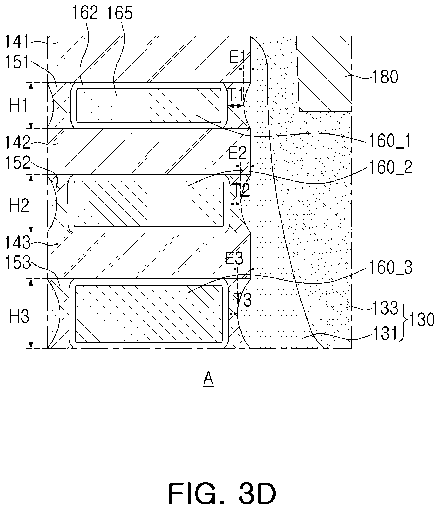

Referring to FIG. 3D together with FIG. 2, the extent to which the side of the source/drain region 130 protrudes toward the gate electrode 165 between the plurality of channel layers 141, 142, and 143 may vary depending on the level. Unlike the example embodiment of FIG. 3C, the distance at which the side portions of the source/drain region 130 in contact with the first to third inner spacers 151, 152, and 153 protrude toward the gate structure 160 may vary depending on the heights H1, H2, and H3 of the first to third inner spacers 151, 152, and 153. For example, the protrusion distance E2 of the side portion of the source/drain region 130 in contact with the second inner spacer 152 may be greater than the protrusion distance E1 of the side portion in contact with the first inner spacer 151, and the protrusion distance E3 of the side portion thereof in contact with the third inner spacer 153 may be greater than the protrusion distance E2 of the side portion in contact with the second inner spacer 152. In this case, as in the example embodiment of FIG. 3A, the central thickness T2 of the second inner spacer 152 may be smaller than the central thickness T1 of the first inner spacer 151, and the central thickness T3 of the third inner spacer 153 may be smaller than the central thickness T2 of the second inner spacer. For example, the protrusion distance of the source/drain region 130 toward the gate structure 160 may increase as the height of the contacting inner spacer increases. Depending on example embodiments, on the contrary, the protrusion distance at which the source/drain region 130 protrudes toward the gate structure 160 may decrease as the height of the contacting inner spacer increases.

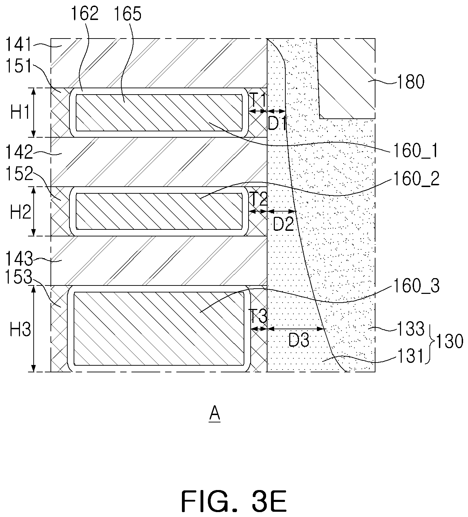

Referring to FIG. 3E together with FIG. 2, some of the plurality of inner spacers 150 may have substantially the same height and thickness. For example, the height H1 of the first inner spacer 151 and the height H2 of the second inner spacer 152 may be substantially the same, and the central thickness T1 of the first inner spacer 151 and the central thickness T2 of the second inner spacer 152 may be substantially the same. The height H3 of the third inner spacer 153 may be greater than the height H1 of the first inner spacer 151 and the height H2 of the second inner spacer 152, and the central thickness T3 of the third inner spacer 153 may be smaller than the central thickness T1 of the first inner spacer 151 and the central thickness T2 of the second inner spacer 152. Accordingly, the height H1 of the first gate portion 160_1 and the height of the second gate portion 160_2 may be substantially the same, and the height of the third gate portion 160_3 may be greater than the height H1 of the first gate portion 160_1 and the height H2 of the second gate portion 160_2. For example, some of the plurality of inner spacers 151, 152, and 153 may have substantially the same height or thickness even if they are disposed on different levels, and these features may also be applied to the example embodiments of FIGS. 3A to 3D, and various modifications may be made.

The example embodiments of FIGS. 3A to 3E described above are examples, and the detailed configuration and arrangement relationship, contact relationship, thickness and presence of each component, or the like of the gate structure 160 including the gate electrode 165, the source/drain region 130, and the inner spacer 150 are not limited thereto and may be modified in various manners.

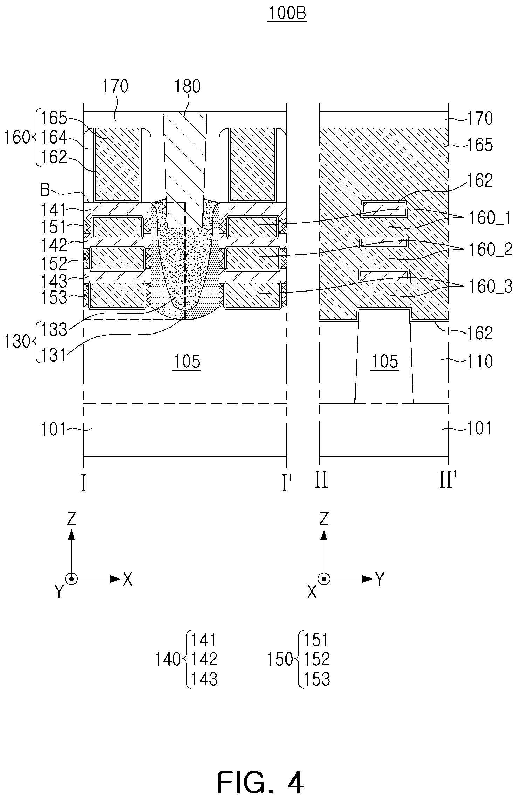

FIG. 4 is a schematic cross-sectional view illustrating a semiconductor device according to example embodiments. FIG. 4 schematically illustrates cross-sections corresponding to cross-sections of the semiconductor device of FIG. 1 along cutting lines I-I' and II-II'.

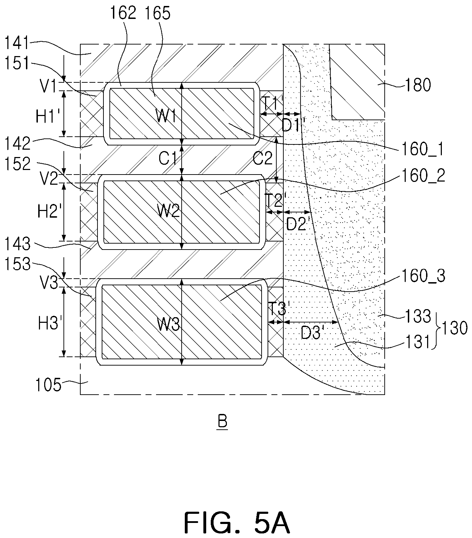

FIG. 5A is a partially enlarged view illustrating a semiconductor device according to example embodiments. FIG. 5A illustrates an enlarged view of the area 'B' of the semiconductor device in FIG. 4.

Referring to FIGS. 4 to 5A, in a semiconductor device 100B, the first to third gate portions 160_1, 160_2, and 160_3 extend in a third direction (for example, Z-direction), and may extend into the first to third channel layers 141, 142, and 143 and the active region 105. Accordingly, the height W1 of the first gate portion 160_1 may be greater than the height H1' of the first inner spacer 151, the height W2 of the second gate portion 160_2 may be greater than the height H2' of the second inner spacer 152, and the height W3 of the third gate portion 160_3 may be greater than the height H3' of the third inner spacer 153. The height of the central portion of each of the first to third channel layers 141, 142, and 143 may be smaller than the height of side portions of each of the first to third channel layers 141, 142, and 143 in the first direction (for example, X-direction). In this case, the height of the central portion may be understood to refer to the height at the center in the first direction (for example, X-direction). For example, the height C1 of the central portion of the second channel layer 142 may be smaller than the height C2 of the side that contacts the source/drain region 130. The lower-surface portion in contact with the first gate portion 160_1 in the lower surface of the first channel layer 141 may be disposed on the same level as or higher than the lower-surface portion contacting the first inner spacer 151. The lower-surface portion contacting the second gate portion 160_2 in the lower surface of the second channel layer 142 may be disposed on the same level as or higher than the lower-surface portion contacting the second inner spacer 152. The upper-surface portion contacting the first gate portion 160_1 in the upper surface of the second channel layer 142 may be disposed on the same level as or lower than the upper-surface portion in contact with the first inner spacer 151. The lower-surface portion of the third channel layer 143 that contacts the third gate portion 160_3 may be disposed on the same level as or higher level than the lower-surface portion contacting the third inner spacer 153. The upper-surface portion contacting the second gate portion 160_2 in the upper surface of the third channel layer 143 may be disposed on the same level as or lower than the upper-surface portion in contact with the second inner spacer 152. The upper-surface portion contacting the third gate portion 160_3 in the upper surface of the active region 105 may be disposed on the same level as or lower level than an upper-surface portion that contacts the third inner spacer 153. The lengths V1, V2, and V3 of the first to third gate portions 160_1, 160_2, and 160_3 extending into the first to third channel layers 141, 142, and 143, respectively, may be substantially the same.

As the gate portions 160_1, 160_2, and 160_3 are respectively enlarged in the third direction (for example, Z-direction), the plurality of channel layers 141, 142, and 143 may have a dog bone shape in which the central height is smaller than the side height. In this embodiment, since the side heights of the plurality of channel layers 141, 142, and 143 are maintained, the electrical characteristics of the plurality of channel layers 141, 142, and 143 do not deteriorate and may be maintained or improved.

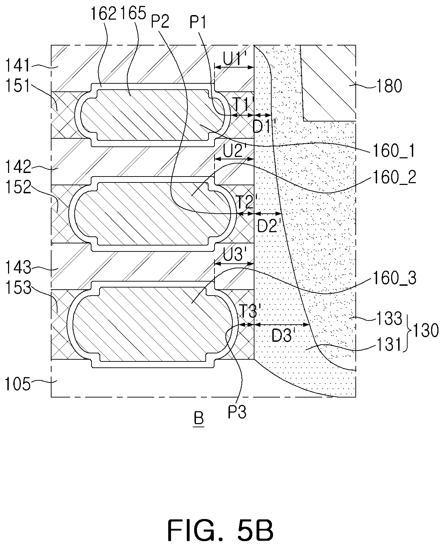

FIGS. 5B to 5D are partially enlarged views illustrating semiconductor devices according to example embodiments. FIGS. 5B to 5D illustrate enlarged areas corresponding to the enlarged area 'B' of the semiconductor device in FIG. 4, and illustrate modified examples of FIG. 5A. The detailed form of the plurality of inner spacers 150 is not limited to the example embodiments of FIGS. 5A to 3D.

Referring to FIG. 5B together with FIG. 4, the first to third gate portions 160_1, 160_2, and 160_3 may respectively have a convexly rounded side face toward the first to third inner spacers 151, 152, and 153. The first protruding end P1, where the first gate portion 160_1 protrudes most toward the source/drain region 130, may contact a portion of the first inner spacer 151 having a minimum thickness T1', and may be spaced apart from the first and second channel layers 141 and 142. The distance U1' between the upper end of the first gate portion 160_1 and the source/drain region 130 may be greater than the central thickness T 1' of the first inner spacer 151. The distance between the lower end of the first gate portion 160_1 and the source/drain region 130 may also be greater than the central thickness T 1' of the first inner spacer 151. Likewise, the protruding end P2 of the second gate portion 160_2 that protrudes most toward the source/drain region 130 may contact the portion of the second inner spacer 152 having the minimum thickness T2' and may be spaced apart from the second and third channel layers 142 and 143. The distance U2' between the upper end of the second gate portion 160_2 and the source/drain region 130 may be greater than the central thickness T2' of the second inner spacer 152. The distance between the lower end of the second gate portion 160_2 and the source/drain region 130 may also be greater than the central thickness T1' of the second inner spacer 152. Likewise, the protruding end P3 of the third gate portion 160_3 that protrudes most toward the source/drain region 130 may contact the portion of the third inner spacer 153 having the minimum thickness T3', and may be spaced apart from the third channel layer 143 and the active region 105. The distance U3' between the upper end of the third gate portion 160_3 and the source/drain region 130 may be greater than the central thickness T3' of the third inner spacer 152. The distance between the lower end of the third gate portion 160_3 and the source/drain region 130 may also be greater than the central thickness T3' of the third inner spacer 153.

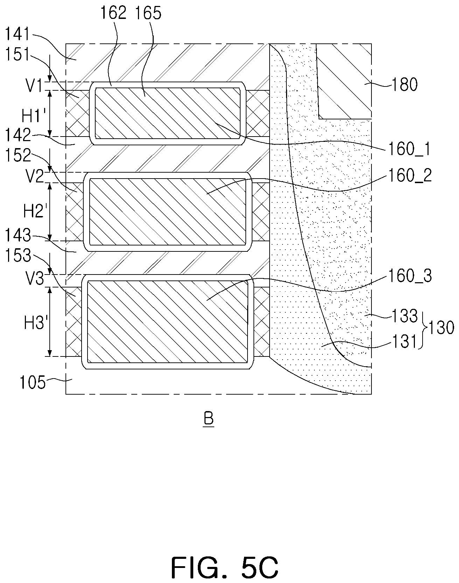

Referring to FIG. 5C together with FIG. 4, the distances V1, V2, and V3 that the plurality of gate portions 160_1, 160_2, and 160_3 extend into the plurality of channel layers 141, 142, and 143, respectively, may be different. For example, the distance V2 by which the second gate portion 160_2 extends into the second channel layer 142 may be greater than the distance V1 by which the first gate portion 160_1 extends into the first channel layer 141, and the distance V3 by which the third gate portion 160_3 extends into the third channel layer 143 may be greater than the distance V2 by which the second gate portion 160_2 extends into the second channel layer 142. For example, in the case of the plurality of gate portions 160_1, 160_2, and 160_3, as the widths thereof in the first direction (for example, X-direction) increase, the distances extending inside the plurality of respective channel layers 141, 142, and 143 may increase. Depending on example embodiments, on the contrary, as the widths of the plurality of gate portions 160_1, 160_2, and 160_3 in the first direction (for example, X-direction) increase, the distances thereof extending inside the plurality of respective channel layers 141, 142, and 143 may decrease.

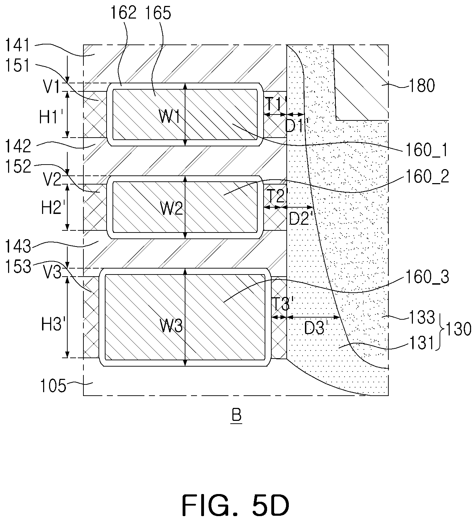

Referring to FIG. 5D together with FIG. 4, like the example embodiment of FIG. 3E, some of the plurality of inner spacers 150 may have substantially the same height and thickness. For example, the height H1' of the first inner spacer 151 and the height H2' of the second inner spacer 152 may be substantially the same, and the central thickness T1' of the first inner spacer 151 and the central thickness T2 of the second inner spacer 152 may be substantially the same. The height H3' of the third inner spacer 153 may be greater than the height H1' of the first inner spacer 151 and the height H2' of the second inner spacer 152, and the central thickness T3' of the third inner spacer 153 may be smaller than the central thickness T1' of the first inner spacer 151 and the central thickness T2' of the second inner spacer 152. Accordingly, the central height W1 of the first gate portion 160_1 and the central height W2 of the second gate portion 160_2 may be substantially the same. The central height W3 of the third gate portion 160_3 may be greater than the central height W1 of the first gate portion 160_1 and the central height W2 of the second gate portion 160_2. For example, some of the first to third gate portions 160_1, 160_2, and 160_3 may have substantially the same height or thickness even if they are disposed at different levels, and these features may also be applied to the example embodiments of FIGS. 5A to 5C, and various modifications may be made.

Compatible features of the example embodiments of FIGS. 3A to 3E and the example embodiments of FIGS. 5A to 5D may be applied simultaneously to one semiconductor device. For example, in example embodiments, some of the gate portions 160_1, 160_2, and 160_3 have a shape extending in a third direction (for example, Z-direction) as in the example embodiment of FIG. 5A, and the remaining part may have the same height as the inner spacer at the same level, as illustrated in FIG. 3A.

In the above embodiments, each of the semiconductor devices 100A of FIGS. 1 and 2 and the semiconductor device 100B of FIG. 4 includes the channel structure 140, the source/drain region 130 with the contact structure 180 thereon, the gate structure 160 and the inner spacers 130 formed on the substrate 101 with the active region 105. However, the disclosure is not limited thereto. According to one or more other embodiments, each of the semiconductor devices 100A and 100B may include a backside isolation structure which has at least partially replaced the substrate 101 and the active region 105 so that a backside contact structure instead of the contact structure 180 can be formed to connect the source/drain region 180 to a voltage source or another circuit element through the backside isolation structure.

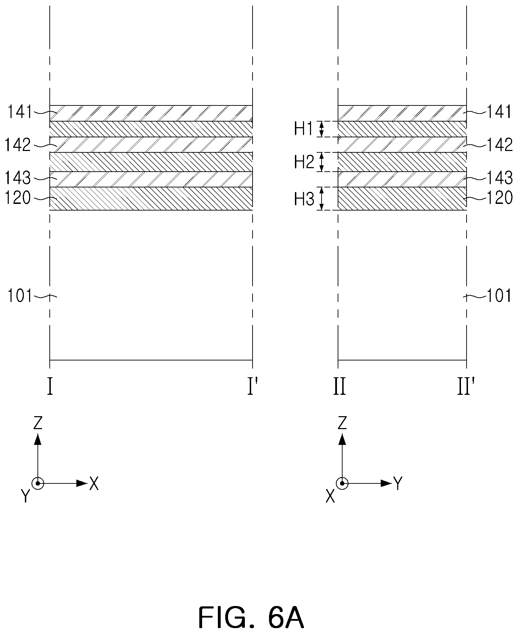

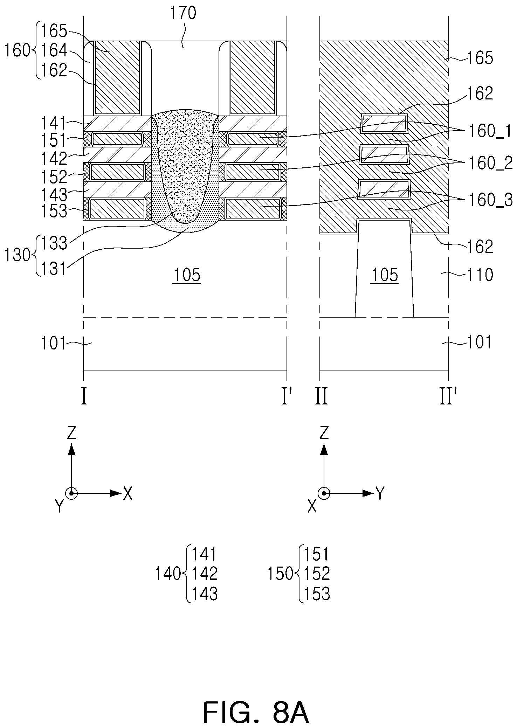

FIGS. 6A to 6F and FIGS. 8A to 8B are cross-sectional views illustrated according to a process sequence to describe a method of manufacturing a semiconductor device according to example embodiments. FIGS. 6A to 6F and FIGS. 8A to 8B illustrate cross sections corresponding to FIG. 2.

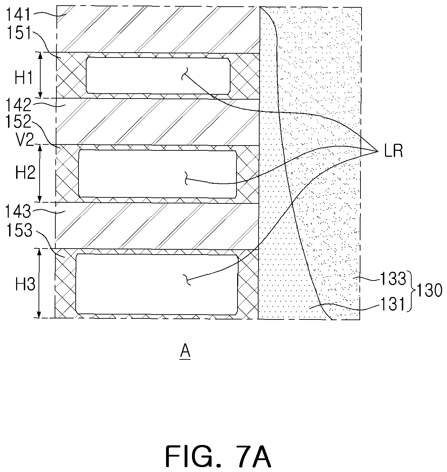

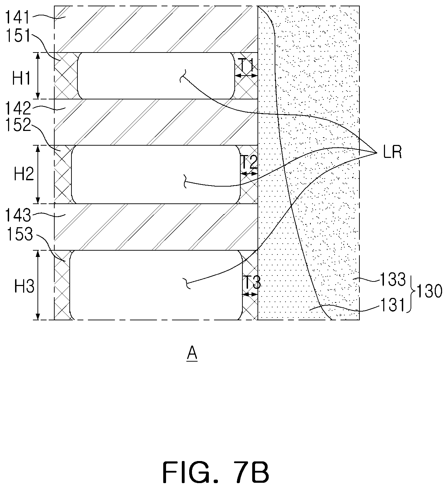

FIGS. 7A and 7B are partially enlarged views illustrating a process sequence to describe a method of manufacturing a semiconductor device according to example embodiments. FIGS. 7A and 7B illustrate enlarged views corresponding to FIG. 3A.

Referring to FIG. 6A, a plurality of sacrificial layers 120 and a plurality of channel layers 141, 142, and 143 may be alternately stacked on the substrate 101.

The substrate 101 may include silicon (Si), germanium (Ge), or silicon germanium (SiGe). The substrate 101 may include a bulk wafer, an epitaxial layer, a Silicon On Insulator (SOI) layer, or a Semiconductor On Insulator (SeOI) layer.

The plurality of channel layers 141, 142, and 143 may include first to third channel layers 141, 142, and 143. The sacrificial layers 120 may be layers that are replaced with the gate dielectric layers 162 and gate electrodes 165 below the first channel layer 141 through a subsequent process, as illustrated in FIG. 2. The thicknesses H1, H2, and H3 of the alternately stacked sacrificial layers 120 may be formed differently. For example, the thickness H3 of the sacrificial layer 120 disposed at the lowest level may be greater than the thickness H1 of the sacrificial layer 120 disposed at the highest level. To vary the thickness of the inner spacers 150 of FIG. 2 through subsequent processes, the sacrificial layers 120 may be stacked with different thicknesses in this stage. The sacrificial layers 120 may be formed of a material respectively having etch selectivity with respect to the first to third channel layers 141, 142, and 143. The first to third channel layers 141, 142, and 143 may include a material different from a material of the sacrificial layers 120. The sacrificial layers 120 and the first to third channel layers 141, 142, and 143 include a semiconductor material containing at least one of, for example, silicon (Si), silicon germanium (SiGe), and germanium (Ge), while these semiconductor layers may contain different substances and may or may not contain impurities. For example, the sacrificial layers 120 may include silicon germanium (SiGe), and the first to third channel layers 141, 142, and 143 may include silicon (Si).

The sacrificial layers 120 and the first to third channel layers 141, 142, and 143 may be formed one after another by performing an epitaxial growth process from the stack structure. The number of layers of the channel layers alternately stacked with the sacrificial layers 120 may vary in various embodiments.

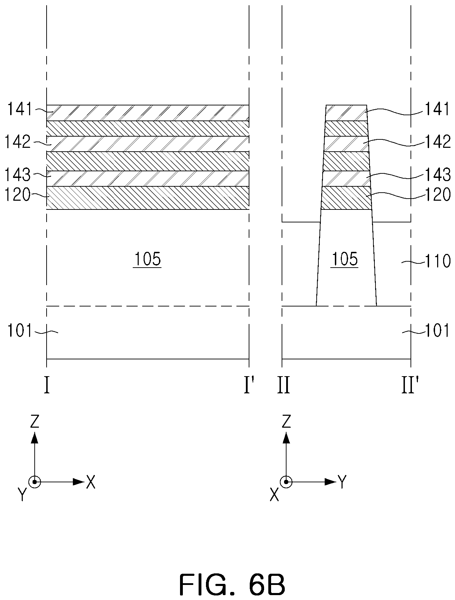

Referring to FIG. 6B, the sacrificial layers 120, the first to third channel layers 141, 142, and 143, and the substrate 101 are partially removed to form an active structure including an active region 105, and a device isolation layer 110 may be formed.

The active structure may include an active region 105, sacrificial layers 120, and first to third channel layers 141, 142, and 143. The active structure may be formed in the form of a line extending in one direction, for example, the X-direction, and may be formed to be spaced apart from adjacent active structures in the Y-direction. The sides of the active structure in the Y-direction are coplanar with each other and may be disposed on a straight line.

After filling the area in which respective portions of the active region 105, the sacrificial layers 120, and the first to third channel layers 141, 142, and 143 were removed, with an insulating material, the device isolation layer 110 may be formed by partially removing the insulating material so that the active region 105 protrudes. The upper surface of the device isolation layer 110 may be formed to be lower than the upper surface of the active region 105.

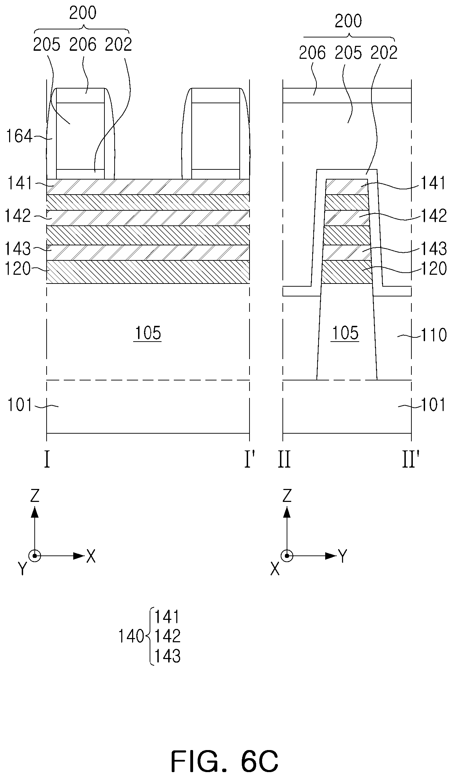

Referring to FIG. 6C, sacrificial gate structures 200 and gate spacer layers 164 may be formed on the active structure.

Each of the sacrificial gate structures 200 may be a sacrificial structure formed through a subsequent process in an area where the gate dielectric layers 162 and the gate electrode 165 are disposed, on the channel structure 140, as illustrated in FIG. 2. The sacrificial gate structures 200 may have a line shape that extends in one direction and intersects the active structure. The sacrificial gate structures 200 may extend, for example, in the Y-direction. Each of the sacrificial gate structures 200 may include first and second sacrificial gate layers 202 and 205 and a mask pattern layer 206, sequentially stacked. The first and second sacrificial gate layers 202 and 205 may be patterned using the mask pattern layer 206.

The first and second sacrificial gate layers 202 and 205 may be an insulating layer and a conductive layer, respectively, but are not limited thereto. The first and second sacrificial gate layers 202 and 205 may be formed as one layer. For example, the first sacrificial gate layer 202 may include silicon oxide, and the second sacrificial gate layer 205 may include polysilicon. The mask pattern layer 206 may include silicon oxide and/or silicon nitride.

The gate spacer layers 164 may be formed on both sidewalls of the sacrificial gate structures 200. The gate spacer layers 164 may be formed of a low dielectric constant material and may include at least one of, for example, SiO, SiN, SiCN, SiOC, SiON, and SiOCN.

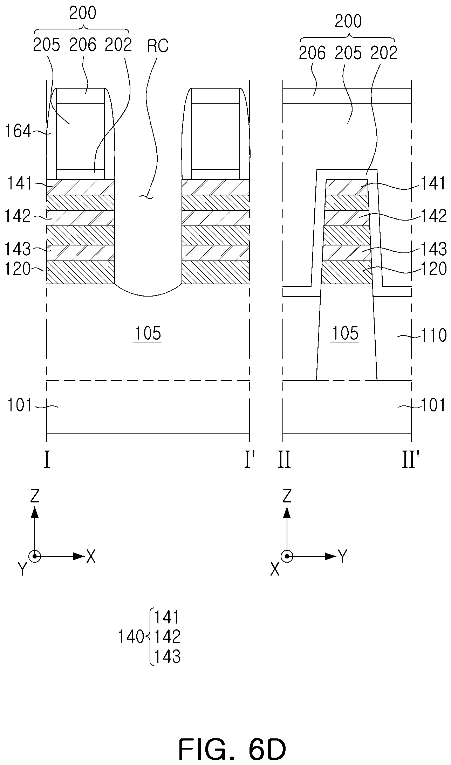

Referring to FIG. 6D, an etching process using the sacrificial gate structures 200 as an etch mask may be performed to form a recess region RC that penetrates the active structure and exposes the active region 105.

A recess region RC may be formed by partially removing the sacrificial layers 120 and the first to third channel layers 141, 142, and 143 exposed from the sacrificial gate structures 200, and the sacrificial layers 120 may be partially removed. As a result, the first to third channel layers 141, 142, and 143 may form channel structures 140 having a limited length in the X-direction.

At this stage, the sacrificial layers 120 may be selectively etched, for example, with respect to the channel structures 140 and removed to a predetermined depth from the side in the X-direction. The sacrificial layers 120 may have sides that are concave inward by side etching as described above. In this case, the source/drain region 130 with curved sides as illustrated in FIGS. 3C to 3D may be formed through a subsequent process.

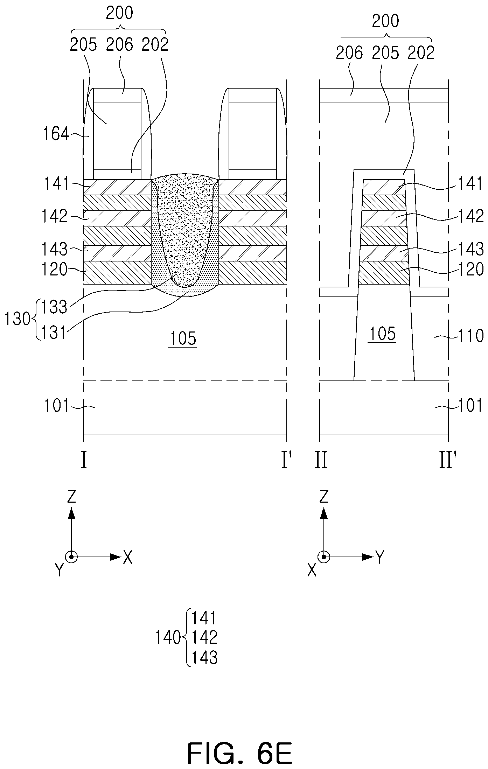

Referring to FIG. 6E, a source/drain region 130 may be formed in the recess region RC.

The source/drain regions 130 are formed within the recess regions RC and may be formed by growing from the sides or side surfaces of the channel structures 140 and the active region 105 by, for example, a selective epitaxial process. The source/drain region 130 may include a plurality of epitaxial layers, and these epitaxial layers may have different non-silicon concentrations. For example, after first forming the first epitaxial layer 131 on the side surfaces of the plurality of channel layers 141, 142, and 143, the side surfaces of the sacrificial layers 120, and the upper surface of the active region 105 exposed by the recess region; a second epitaxial layer 133 filling the remaining portion of the recess region RC may be formed on the first epitaxial layer 131. The first epitaxial layer 131 may have a first concentration of non-silicon, and the second epitaxial layer 133 may have a second concentration of non-silicon, higher than the first concentration. The source/drain region 130 may contain impurities through in-situ doping, and may include a plurality of layers having different doping elements and/or doping concentrations.

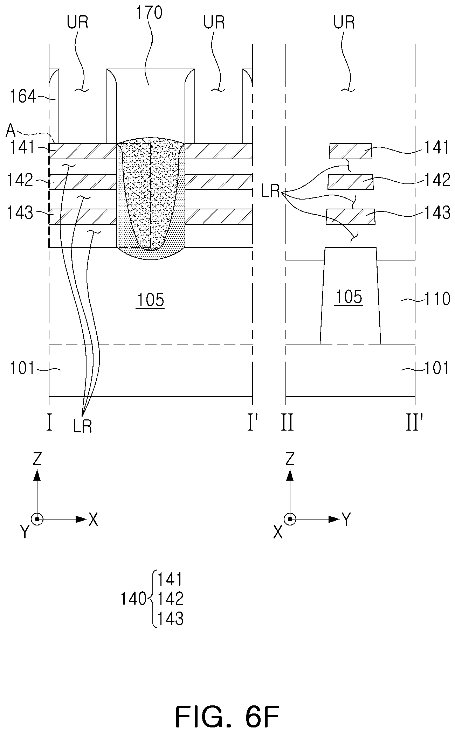

Referring to FIG. 6F, the interlayer insulating layer 170 may be partially formed, and the sacrificial gate structures and the sacrificial layers may be removed.

The interlayer insulating layer 170 may be formed by forming an insulating film on the sacrificial gate structures 200 and the source/drain regions 130 and performing a planarization process.

The sacrificial gate structures 200 and the sacrificial layers 120 may be removed selectively with respect to the gate spacer layers 164 and the channel structures 140. First, the sacrificial gate structures 200 are removed to form upper gap regions UR, and the sacrificial layers 120 exposed through the upper gap regions UR may be removed to form lower gap regions LR. For example, when the sacrificial layers 120 include silicon germanium (SiGe) and the channel structures 140 include silicon (Si), the sacrificial layers 120 may be selectively removed with respect to the channel structures 140 by performing a wet etching process.

Referring to FIG. 7A together with FIG. 6F, a plurality of inner spacers 151, 152, and 153 may be formed below the plurality of channel layers 141, 142, and 143, respectively.

The plurality of inner spacers 151, 152 and 153 may be formed along the surface of the source/drain region 130 and the surfaces of the plurality of channel layers 141, 142, and 143 within the lower gap regions LR on the active region 105. Depending on the heights of respective lower gap regions LR, the thicknesses at which the plurality of inner spacers 151, 152, and 153 are formed may vary. For example, the height H3 of a portion of the lower gap region LR where the third inner spacer 153 is formed may be greater than the height H1 of a portion of the lower gap region LR where the first inner spacer 151 is formed, and a thickness on the side where the third inner spacer 153 is formed on the source/drain region 130 may be greater than a thickness on the side where the first inner spacer 151 is formed on the source/drain region 130. For example, the greater the heights of respective portions of the lower gap regions LR, the smaller the thicknesses of the side surfaces of the plurality of respective inner spacers 151, 152, and 153 on the source/drain region 130 may be formed.

Referring to FIG. 7B together with FIG. 6F, the plurality of inner spacers 151, 152, and 153 may be partially etched to expose the plurality of channel layers 141, 142, and 143 on the lower gap region LR.

Depending on the heights of respective lower gap regions LR, the central thicknesses T1, T2, and T3 of the plurality of respective inner spacers 151, 152, and 153 may be formed in various manners. For example, the central thickness T3 of the third inner spacer 153, which has a height H3 greater than the height H1 of the first inner spacer 151, may be formed to be smaller than the central thickness T1 of the first inner spacer 151. Accordingly, a plurality of inner spacers 151, 152, and 153 having various thicknesses may be formed without increasing process difficulty.

Various modified embodiments of FIGS. 3A to 3E may be provided depending on differences in the shape, thickness, the degree of etching of the plurality of inner spacers 151, 152, and 153, and the like. The side surfaces of the plurality of inner spacers 151, 152, and 153 in contact with the source/drain region 130 may be determined according to the surface form of the side surface of the source/drain region 130. The side surfaces of the plurality of inner spacers 151, 152, and 153 in contact with the gate structure 160 may be modified in various manners, by not only the height of each of the plurality of inner spacers 151, 152, and 153, but also the type of respectively included insulating material, amount of insulating material, forming method, etching method, etching time, or the like.

Referring to FIG. 8A, the gate structures 160 may be formed by forming gate dielectric layers 162 and gate electrode 165.

The gate structures 160 may be formed to fill upper gap regions UR and lower gap regions LR. The gate dielectric layers 162 may be formed to be conformally disposed on inner surfaces of the upper gap regions UR and the lower gap regions LR. The gate electrode 165 is formed to completely fill the upper gap regions UR and the lower gap regions LR, and may then be removed from the upper portions of the upper gap regions UR to a predetermined depth along with the gate dielectric layers 162 and the gate spacer layers 164. As a result, the gate structures 160 respectively including gate dielectric layers 162, gate electrode 165, and gate spacer layers 164 may be formed.

The gate dielectric layers 162, the gate electrode 165, and the gate spacer layers 164 may be formed to continuously extend in the Y-direction and then removed in some areas through an etching process. As a result, gate structures 160 separated from each other in the Y-direction may be formed.

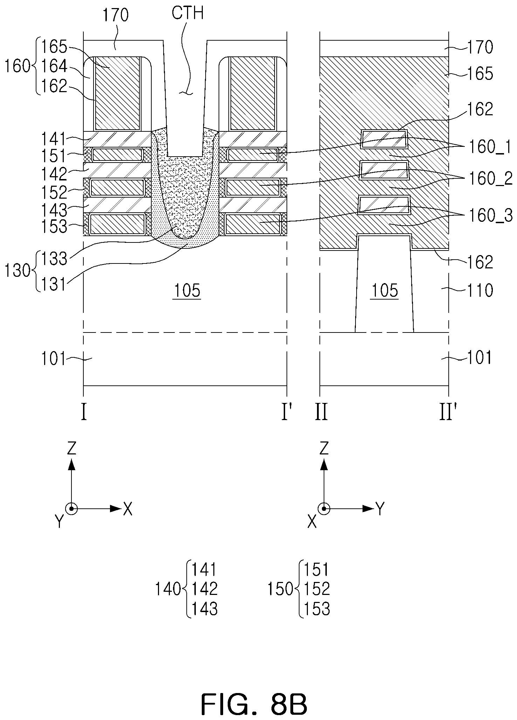

Referring to FIG. 8B, an interlayer insulating layer 170 is further formed on the gate structures 160, and a contact hole CTH may be formed to penetrate through the interlayer insulating layer 170 and extend into the source/drain region 130.

The contact hole CTH may be formed on the source/drain region 130 by penetrating through the interlayer insulating layer 170 and partially etching the source/drain region 130 from the upper surface. Thereafter, referring to FIG. 2, the contact structure 180 may be formed by depositing a conductive material that fills the contact hole CTH. Depending on example embodiments, after forming the contact structure 180, the contact structure 180 and the interlayer insulating layer 170 may be partially etched from the upper surface through a planarization process.

Hereinafter, descriptions that overlap with the description of the manufacturing method with reference to FIGS. 6A to 8B will be omitted.

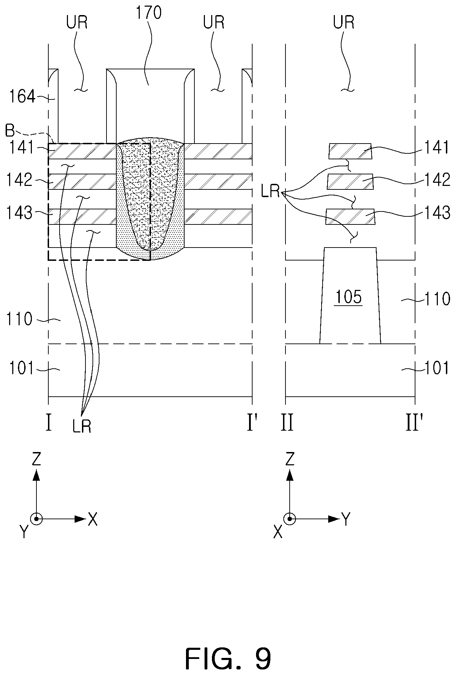

FIG. 9 is a cross-sectional view illustrating a process sequence to describe a method of manufacturing a semiconductor device according to example embodiments. FIG. 9 illustrates the area corresponding to FIG. 4.

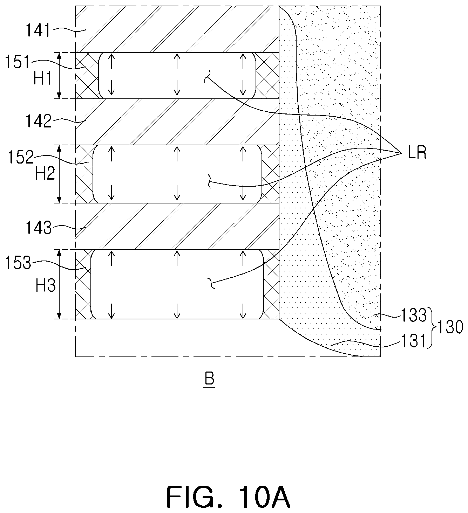

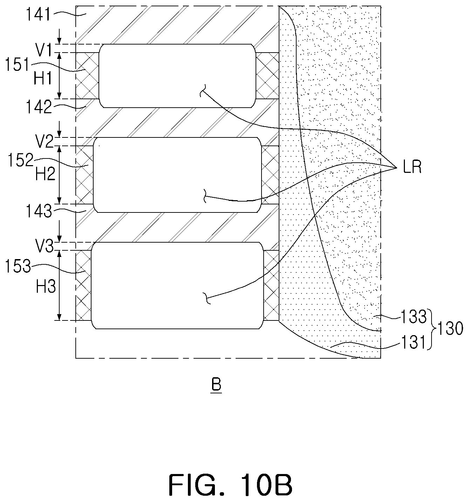

FIGS. 10A and 10B are partially enlarged views illustrating a process sequence to describe a method of manufacturing a semiconductor device according to example embodiments. FIGS. 10A to 10E illustrate enlarged views corresponding to FIG. 5A.

Referring to FIGS. 9 and 10A to 10B, after forming a plurality of inner spacers 151, 152, and 153, the portion of the active region 105 and the plurality of channel layers 141, 142, and 143 exposed by the lower gap regions LR may be etched.

This operation may be understood as a step that proceeds after the manufacturing process described with reference to FIGS. 7A to 7B. The lower gap regions LR may be enlarged in a third direction (for example, Z-direction) and extend into the plurality of channel layers 141, 142, and 143 and the active region 105. Depending on etch selectivity, the plurality of inner spacers 151, 152, and 153 are not etched, and portions of the active region 105 and the plurality of channel layers 141, 142, and 143 exposed by the lower gap regions LR may be partially etched. Depending on the shape, thickness, height and the like of the plurality of respective inner spacers 151, 152, and 153, enlarged distances V1, V2, and V3 of the respective lower gap regions LR may be modified in various manners.

As set forth above, a semiconductor device having improved reliability may be provided by optimizing a structure or material of an inner spacer according to a source/drain conductivity type.

While example embodiments have been illustrated and described above, it will be apparent to those skilled in the art that modifications and variations could be made without departing from the scope of the appended claims.

## Claims

1. A semiconductor device comprising:
a gate structure (160) having a side in a first direction (X) and extending in a second direction (Y) intersecting the first direction (X);
a source/drain region (130) on the side of the gate structure (160);
a plurality of channel layers (141, 142, 143) spaced apart from each other in a third direction (Z) intersecting the first direction (X) and the second direction (Y) and surrounded by the gate structure (160); and
a plurality of inner spacers (150) between the gate structure (160) and the source/drain region (130),
wherein the plurality of inner spacers (150) have respective heights (H1, H2, H3) in the third direction (Z) increasing in the third direction (Z) toward bottom, and have respective thicknesses (T1, T2, T3) in the first direction (X) decreasing in the third direction (Z) toward bottom.

2. The semiconductor device of claim 1, wherein the plurality of inner spacers (150) comprise a first inner spacer (151), a second inner spacer (152), and a third inner spacer (153) sequentially disposed in the third direction (Z) from top.

3. The semiconductor device of claim 2, wherein in the first direction (X), a distance (T1) between a portion of the gate structure (160) on the first inner spacer (151) and the source/drain region (130) is greater than a distance (T3) between a portion of the gate structure (160) on the third inner spacer (153) and the source/drain region (130), and/or
wherein a side portion of the source/drain region (130) on the third inner spacer (153) protrudes further than a side portion of the source/drain region (130) on the first inner spacer (151) and a side portion of the source/drain region (130) on the second inner spacer (152), toward the gate structure (160).

4. The semiconductor device of claim 2 or 3, wherein the plurality of channel layers (141, 142, 143) comprise a first channel layer (141), a second channel layer (142), and a third channel layer (143) sequentially disposed in the third direction (Z) from top.

5. The semiconductor device of claim 4, wherein the source/drain region (130) comprises a first epitaxial layer (131) on the plurality of channel layers (141, 142, 143) and a second epitaxial layer (133) on the first epitaxial layer (131), the second epitaxial layer (133) having a greater concentration of a non-silicon element than the first epitaxial layer (131), and
wherein, in the first direction (X), a distance (D3) between the third inner spacer (153) and the second epitaxial layer (133) is greater than each of a distance (D1) at which the first inner spacer (151) is separated from the second epitaxial layer (133) and a distance (D2) at which the second inner spacer (152) is separated from the second epitaxial layer (133).

6. The semiconductor device of claim 4 or 5,
wherein a contact area of the first channel layer (141) and the first inner spacer (151) is greater than a contact area of the third channel layer (143) and the third inner spacer (153).

7. The semiconductor device of any one of claims 4 to 6,
wherein a height (H3) of the third inner spacer (153) is greater than a height of the third channel layer (143) in the third direction (Z).

8. The semiconductor device of any one of claims 4 to 7, wherein, at a lower surface of the second channel layer (142), a lower-surface portion on the gate structure (160) is disposed on the same level or a higher level than a lower-surface portion on the second inner spacer (152), and
wherein at an upper surface of the second channel layer (142), an upper-surface portion on the gate structure (160) is disposed on the same level or a lower level than an upper-surface portion on the first inner spacer (151).

9. The semiconductor device of any one of claims 1 to 4, wherein the source/drain region (130) comprises a first epitaxial layer (131) on the plurality of channel layers (141, 142, 143) and a second epitaxial layer (133) on the first epitaxial layer (131),
wherein the first epitaxial layer (131) comprises a first concentration of a non-silicon element,
wherein the second epitaxial layer (133) comprises a non-silicon element of a second concentration greater than the first concentration, and
wherein a distance between the second epitaxial layer (133) and the gate structure (160) in the first direction (X) increases in the third direction (Z) toward bottom.

10. The semiconductor device of any one of claims 1 to 9, wherein side portions of the source/drain region (130) on the plurality of inner spacers (150) protrude further than side portions of the source/drain region (130) on the plurality channel layers (141, 142, 143), toward the gate structure (160).

11. The semiconductor device of any one of claims 1 to 10, wherein, in the third direction (Z), a height (C1) of a central portion of each of the plurality of channel layers (141, 142, 143) is smaller than a height (C2) of a side portion of each of the plurality of channel layers (141, 142, 143) facing the source/drain region (130).

12. The semiconductor device of any one of claims 1 to 11, wherein at least one of the plurality of inner spacers (150) has a side surface on the gate structure (160), concave toward the gate structure (160), and/or
wherein at least one of the plurality of inner spacers (150) has a side surface on the source/drain region (130), concave toward the source/drain region (130).

13. The semiconductor device of any one of claims 1 to 12, wherein a central thickness (T1', T2', T3') of each of the plurality of inner spacers (150) in the first direction (X) is smaller than an upper thickness (U1', U2', U3') of the each of the plurality of inner spacers (150) in the first direction (X).

14. The semiconductor device of any one of claims 1 to 13, wherein a central thickness (T1', T2', T3') of each of the plurality of inner spacers (150) in the first direction (X) is smaller than a lower thickness of the each of the plurality of inner spacers (150) in the first direction (X).

15. The semiconductor device of any one of claims 1 to 14, wherein at least two inner spacers (151, 152) have the same height in the third direction (Z) and the same thickness in the first direction (X) which are different from a height and a thickness of another inner spacer (153), respectively.
